(19) Europäisches Patentamt / European Patent Office / Office européen des brevets

(11) **EP 1 719 124 B1**

(12) **EUROPEAN PATENT SPECIFICATION**

(45) Date of publication and mention
of the grant of the patent:
**26.09.2007 Bulletin 2007/39**

(51) Int Cl.:
*G11B 7/125* *(2006.01)*      *H01S 5/062* *(2006.01)*
*H01S 5/0683* *(2006.01)*     *H01S 5/10* *(2006.01)*
*H01S 3/13* *(2006.01)*

(21) Application number: **05702305.3**

(22) Date of filing: **19.01.2005**

(86) International application number:
**PCT/IB2005/000144**

(87) International publication number:
**WO 2005/081236 (01.09.2005 Gazette 2005/35)**

(54) **SYSTEM FOR REDUCING FEEDBACK NOISE DUE TO RELAXATION OSCILLATION IN OPTICAL DATA RECORDING REPRODUCING SYSTEMS USING OPTIMIZED EXTERNAL CAVITY**

SYSTEM ZUR VERRINGERUNG VON RÜCKKOPPLUNGSRAUSCHEN AUFGRUND VON RELAXATIONSOSZILLATION IN OPTISCHEN DATENAUFZEICHNUNGS-WIEDERGABE-SYSTEMEN DURCH VERWENDUNG EINES OPTIMIERTEN EXTERNEN RESONATORS

SYSTEME DE REDUCTION DU RETROBRUIT DU AUX OSCILLATIONS DE RELAXATION DANS UN DISPOSITIF OPTIQUE D'ENREGISTREMENT/LECTURE COMPORTANT UNE CAVITE EXTERIEURE OPTIMISEE

(84) Designated Contracting States:
**AT BE BG CH CY CZ DE DK EE ES FI FR GB GR HU IE IS IT LI LT LU MC NL PL PT RO SE SI SK TR**

(30) Priority: **09.02.2004 EP 04300068**

(43) Date of publication of application:
**08.11.2006 Bulletin 2006/45**

(73) Proprietor: **Koninklijke Philips Electronics N.V.**
**5621 BA Eindhoven (NL)**

(72) Inventors:
• **'T HOOFT, Gert Wim,**
**Société Civile SPID**
**F-75008 Paris (FR)**
• **SCHLEIPEN, Johannes Joseph Hubertina Barbara**
**F-75008 PARIS (FR)**
• **VAN DE NES, Arthur Siewert,**
**Société Civile SPID**
**F-75008 Paris (FR)**

(74) Representative: **van Oudheusden-Perset, Laure E. et al**
**Société Civile SPID**
**156, Boulevard Haussmann**
**75008 Paris (FR)**

(56) References cited:
US-A- 5 034 942          US-A- 5 313 448
US-A- 5 909 425          US-B1- 6 567 440

• **ROY LANG, KOHROH KOBAYASHI: "Suppression of the Relaxation Oscillation in the Modulated Output of Semiconductor Lasers" IEEE JOURNAL OF QUANTUM ELECTRONICS, vol. QE-12, no. 3, March 1976 (1976-03), - March 1976 (1976-03) pages 194-199, XP002326086**
• **JULIUS S. COHEN, RONALD R. DRENTEN, BASTIAAN H. VERBEEK: "The Effect of Optical Feedback on the Relaxation Oscillation in Semiconductor Lasers" IEEE JOURNAL OF QUANTUM ELECTRONICS, vol. 24, no. 10, October 1988 (1988-10), pages 1989-1995, XP002326087**
• **TAKESHI KUROSAKI, TAKUO HIRONO, MITSUO FUKUDA: "Suppression of External Cavity Modes in DFB Lasers with High Endurnce against Optical Feedback" IEEE PHOTONICS TECHNOLOGY LETTERS, vol. 6, no. 8, August 1994 (1994-08), pages 900-902, XP002326088**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

**Description**

**Field of invention**

This invention relates to a system and a method for reducing feedback noise in an optical data recording/ reproducing system such as a compact disc (CD), digital versatile disc (DVD), or Blu-Ray Discs (BD) an optical disc standard based on the use of a blue laser rather than red laser as used for DVDs, and such as a photo-electromagnetic disc i.e. MiniDisc (MD), or magnetooptical disc (MOD). In particular, this invention relates to the use of optimized radio-frequency modulation for reducing feedback noise.

**Background of invention**

European patent application No. EP 0 887 898 discloses a system for providing countermeasures against laser noise (optical feedback noise) by way of optimizing a relationship between the optical length between the laser device and the recording medium (external resonator length) and internal resonator length (L) of a semiconductor laser times effective reflective index (N) of the semiconductor laser. In particular, in the design of the disclosed system a relationship between the disc surface reflection and NL is considered so that even when reflections occur the resulting noise is limited by designing the optical length appropriately.

Further, a method, such as described in American patent application no. US 5,034,942, comprises forming an unexcited saturable absorbing region in part of a resonator so as to induce pulsating light at a laser-inherent frequency. The length of the external cavity (L) is selected together with a laser pulse period (T) so as to achieve a recording/ reproducing system with a reduced noise due to light feedback into the laser.

In addition, American patent no. US 5,313,448, which is considered the closest prior art, discloses a method for controlling a high-frequency pulse current and a pulse oscillation waveform driving a semiconductor laser device. The current and waveform are not substantially influenced by reflected returning light, even if the optical length between the laser device and the recording medium is not constant in a system for recording and reproducing optical information with a semiconductor laser device driven by the high-frequency pulse current. The frequency of the high-frequency pulse current is controlled or the on-off time of the high-frequency pulse current is determined depending on the optical length, so that returning light causing problems arrives at the laser light emitting point at an off time.

None of the above patents or patent application, however, describe laser noise in relation to relaxation oscillation frequency, which is an intrinsic property of the laser.

**Summary of the invention**

An object of the present invention is to provide a method for reducing feedback noise in optical data recording/ reproducing systems, in particular, reducing laser noise induced by optical feedback of relaxation oscillation pulses, emitted by a frequency-modulated laser.

A further object of the present invention is to provide a system for recording/reproducing optical data having reduced feedback noise caused by optical feedback of relaxation oscillation pulses, emitted by a frequency-modulated laser.

A particular advantage of the present invention is provision of a laser capable of a high output level.

A further advantage of the present invention is the provision of a system in which the laser noise due to feedback light in the laser is reduced.

The above objects and advantages together with numerous other objects, advantages and features, which will become evident from the detailed description below, are obtained according to a first aspect of the present invention by a method for reducing feedback noise in optical data recording/reproducing systems comprising a laser driven by current operable to generate a pulsating light emission from said laser to an external cavity defining an optical length (L) from said laser to an optical storage medium, and characterized in that said method comprises: (a) determining relaxation oscillation frequency (ROF) of said pulsating light; and (b) adjusting said optical length (L) according to:

$$L = N \cdot c / (2 \cdot ROF),$$

where N is any integer greater than 0, and c is the speed of light.

The method according to the first aspect of the present invention provides an improved reduction of noise generated by feedback light in a system for recording/reproducing optical data from an optical storage means such as a CD, DVD, Blu-Ray Disc, MDs, or Mos.

The determination of the relaxation oscillation frequency and utilisation of same as an important design parameter for the adjustment of the optical length have surprisingly shown how not only the frequency of the pulsating light but also the relaxation oscillation frequency of each pulse of the pulsating light, in relation to the external cavity length, are of importance for reducing feedback noise.

The current according to the first aspect of the present invention may comprise an alternating current and a direct current. The current may be configured in a wide variety of ways, however, configured so as to control the pulsating light emitting from the laser. The alternating current may comprise square, triangular, sinusoidal shaped waveforms or any combination thereof.

The determination of the relaxation oscillation frequency may be achieved by simulation or measurement of a specific laser driving current configuration, that is, a specific AC and DC driving current.

The current according to the first aspect of the present invention may be operable to generate a pulsating light emission emitted from the laser to the external cavity, wherein the pulsating light emission comprises a series of optical output pulses, having one optical output pulse per period of the current and each optical output pulse showing only one relaxation oscillation pulse.

The above objects, advantages and features together with numerous other objects, advantages and features, which will become evident from the detailed description below, are obtained according to a second aspect of the present invention by a system comprising a laser driven by a current operable to generate a pulsating light emission from said laser to an external cavity defining an optical length (L) from said laser to a optical storage medium, and characterized in that said system has an optical length (L) defined by:

$$L = \cancel{N \cdot c/2 \cdot ROF,}\ N \cdot c / (2 \cdot ROF),$$

where N is any integer greater than zero, ROF is the relaxation oscillation frequency of the pulsating light, and c is the speed of light.

The system according to the second aspect of the present invention may incorporate any features of the method according to the first aspect of the present invention.

The current according to the second aspect of the present invention may be operable to generate a pulsating light emission from the laser to the external cavity, wherein the pulsating light emission comprises a series of optical output pulses, having one optical output pulse per period of the alternating current and each optical output pulse showing only one relaxation oscillation pulse.

## Brief description of the drawings

The above, as well as additional objects, features and advantages of the present invention, will be better understood through the following illustrative and non-limiting detailed description of preferred embodiments of the present invention, with reference to the appended drawing, wherein:

Fig.1 shows system according to a first embodiment of the present invention;
Fig.2 shows a view of a simulation of laser modulation in the system according to the first embodiment of the present invention; and
Fig.3 shows a view of a second simulation of laser modulation in the system according to the first embodiment of the present invention wherein the DC and AC currents are adjusted in such a way that single pulsation per cycle arises.

## Detailed description of preferred embodiments

In the following description of the various embodiments, reference is made to the accompanying figures, which are shown by way of illustration in which the invention may be practiced. It is to be understood that other embodiments may be utilized and structural and functional modifications may be made without departing from the scope of the present invention.

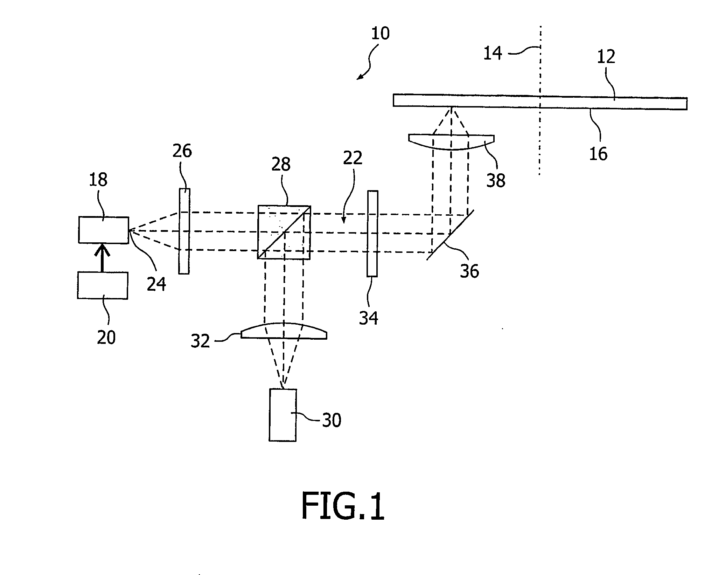

Fig.1 shows a system 10 for recording/reproducing optical data from an optical storage medium 12. The optical storage medium 12 may comprise any type of optical, electro-optical, or magneto-optical storage capabilities, such as a CD, DVD, Blu-Ray Disc, MD or Mos. The optical storage medium 12 is shown in Fig.1 with a symmetry line 14 about which the storage medium 12 may rotate so as to enable access to every part of the surface 16 of the storage medium 12.

The system 10 comprises a laser 18 driven by an AC and a DC current generated by a laser exciter 20 so as to generate a pulsating light 22 emitting from the exit 24 of the laser 18. The AC and DC currents may be selected to control the behaviour of the relaxation oscillations of each pulse of the pulsating light.

The laser 18 is a semiconductor laser of any type generally known by a person skilled in the art.

The emitted pulsating light 22 exits the laser 18 and is projected onto, firstly, a collimator 26 for collimating the pulsating light 22 then, secondly, a polarizing beam splitter 28 for distinguishing (in combination with a quarter-wave plate 34) between the two trajectories from laser 18 to optical storage medium 12 and from optical storage medium 12 to a detector 30. The polarizing beam splitter redirects reflected light from the optical storage medium 12 to the detector 30. The returning light is focused onto the detector 30 by means of a first focussing lens 32.

The polarized pulsating light 22 is fed through the quarter wave plate 34 to a mirror 36 reflecting the polarized pulsating light to a second focusing lens 38. The second focusing lens 38 focuses the pulsating light onto the optical storage medium 12, which is reflected back to the detector 30.

As is known to a person skilled in the art, parts of the reflected light are fed back to the laser 18 thereby introducing noise. By properly adjusting the optical length of the external cavity, which optical length is defined as the optical distance between the exit 24 of the laser 18 to the optical storage medium 12, in accordance with the modulation frequency of the pulsating light a reduction of the noise may be accomplished. Here, optical distance is defined as the length of an optical path in some medium, multiplied by the refractive index of the respective medium.

However, further parameters need to be included in order to further reduce the amount of noise generated by light fed back to the laser 18. The AC and the DC current driving the laser 18 may be adjusted to obtain a specific effect of the emitted pulsating light 22 and in some instances these adjustments of the AC and the DC current will induce relaxation oscillations following each of the pulses in the pulsating light 22. The individual relaxation oscillations are repeated at a relaxation oscillation frequency with a corresponding distance between two consecutive relaxation oscillations. The object of the present invention is to further adjust the optical length of the external cavity to a length matching the wavelength (distance between two consecutive relaxation oscillations) of the relaxation oscillation frequency. Two times the optical length and the distance between two succeeding relaxation oscillations may be matched in any number of integers.

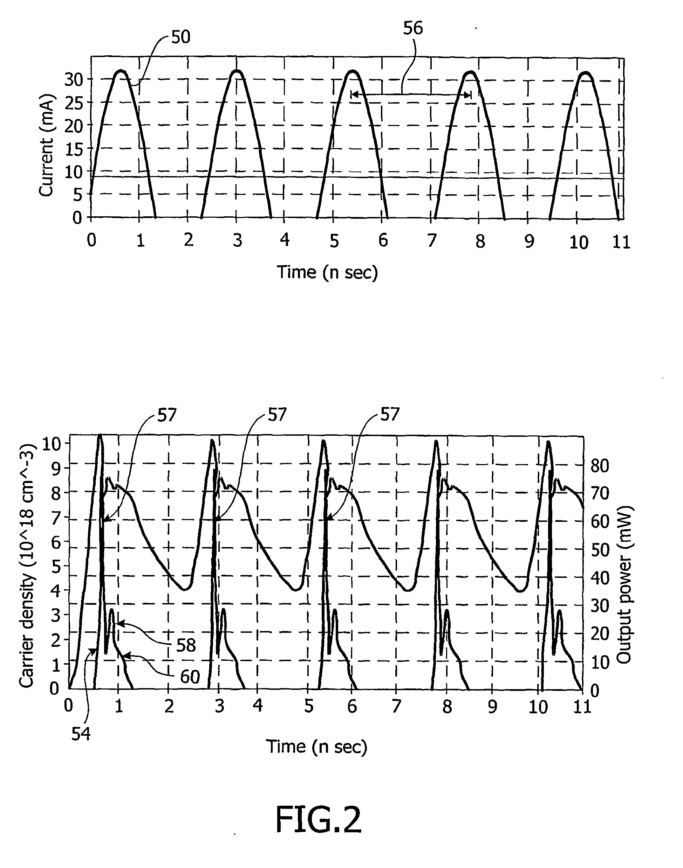

Fig.2 shows a view of a simulation of laser modulation in the system 10. The laser 18 is driven by a current signal 50, comprising an AC component and a DC component. In the simulation the driving current 50 has a DC component of 5 mA and an AC component with an amplitude of about 25 mA resulting in an optical output from the laser 18 of an average of 7 mW.

Using this driving current configuration the laser 18 is pulsating at the frequency of the AC component. The frequency is defined by 1/T where T is the time 56 between two succeeding pulses 57. Furthermore, the laser output 54 shows a strong oscillation for each pulse 57 due to the relaxation oscillation. The relaxation pulses 58 and 60 are not easy to distinguish on the view since the time scale is large. However, for each AC modulation peak, a first relaxation oscillation pulse 57 is followed by a sequence of one or more relaxation oscillation pulses 58, 60 with a frequency of approximately 5 GHz (time period of 200 ps). This frequency has a corresponding wavelength of 6 cm. Hence to reduce feedback noise two times the optical length of the external cavity is set to a multiple (N) of 6 cm, so that the feedback light returns to the laser 18 at the peak of a subsequent pulse 60.

It should be emphasized that any configuration of the driving current may result in introducing relaxation oscillations and thus the optical length of the external cavity may according to this invention be corrected so as to reduce the feedback noise.

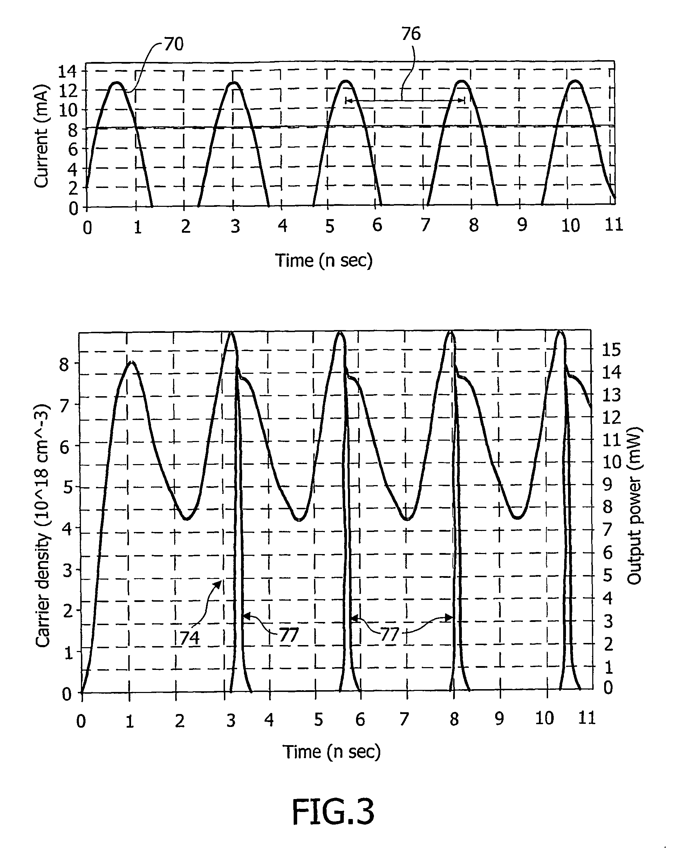

Fig.3 shows a view of a second simulation of laser modulation in the system 10. The laser 18 is driven by a current 70 comprising an AC component and a DC component. In the simulation the DC component is 5 mA and the AC component has an amplitude of 13 mA resulting in an optical output 74 from the laser 18 of an average of 0,7 mW. This driving current configuration gives rise to only one pulse 77 per AC current time period 76. The width of pulse 77 will be less than 100 ps, typically around 30 ps. For large enough optical length L between laser and optical storage medium 12, all feedback light will arrive back at the laser 18 on timescales larger than the width of pulse 77. The laser 18 will be insensitive to this feedback, hence feedback noise will be absent.

**Claims**

1. A method for reducing feedback noise in an optical data recording/reproducing system (10) comprising a laser (18) driven by a current (50, 70) operable to generate a pulsating light (22) emitted from said laser (18) to an external cavity defining an optical length (L) from said laser (18) to an optical storage medium (12), and **characterized in that** said method comprises: (a) determining relaxation oscillation frequency (ROF) of said pulsating light (22); and (b) adjusting said optical length (L) according to:

$$L = \text{N·c/2·ROF,} \quad N \cdot c / (2 \cdot ROF),$$

where N is any integer greater than 0, and c is the speed of light.

2. A method according to claim 1, wherein said optical storage medium (12) comprises a CD, DVD, Blu-Ray Discs, MDs, Mos or any combination thereof.

3. A method according to any one of claims 1 or 2, wherein said determination of the relaxation oscillation frequency comprises simulation or measurement of a specific laser driving current (50, 70) configuration, such as a specific alternating current and direct current driving configuration.

4. A method according to any one of claims 1 to 3, wherein said current (50, 70) is operable to generate a pulsating light (22) emitted from said laser (18) to said external cavity, wherein said pulsating light emission (22) comprises a series of optical output pulses, having one optical output pulse (77) per period (76) of said current and each optical output pulse (77) showing only one relaxation oscillation pulse.

5. A system (10) comprising a laser (18) driven by a current (50, 70) operable to generate a pulsating light (22) emitted from said laser (18) to an external cavity defining an optical length (L) from said laser (18) to an optical storage medium (12), and **characterized in that** said system (10) has an optical length (L) defined by:

$$L = \text{N·c/2·ROF,} \quad N \cdot c / (2 \cdot ROF)$$

where N is any integer greater than zero, ROF is the relaxation oscillation frequency of the pulsating light (22), and c is the speed of light.

6. A system (10) according to claim 5, wherein said current signal (50, 70) is operable to generate a pulsating light emission (22) emitted from said laser (18) to said external cavity, wherein said pulsating light emission (22) comprises a series of optical output pulses, having one optical output pulse (77) per period (76) of said current and each optical output pulse (77) showing only one relaxation oscillation pulse.

**Patentansprüche**

1. Verfahren zum Verringern von Rückkopplungsrauschen in einem optischen Datenaufzeichnungs-/Datenwiedergabesystem (10), das einen Laser (18) umfasst, der durch einem Strom (50, 70) betrieben wird und zur Erzeugung von pulsierendem Licht (22) eingerichtet ist, das von dem Laser (18) zu einem externen Resonator emittiert wird, wodurch eine optische Länge (L) vom Laser (18) zu einem optischen Speichermedium (12) definiert wird, und **dadurch gekennzeichnet, dass** das Verfahren Folgendes umfasst: (a) Bestimmen der Relaxationsschwingungsfrequenz (ROF) des pulsierenden Lichts (22) und (b) Anpassen der optischen Länge (L) gemäß:

$$L = N \bullet c / (2 \bullet ROF)$$

wobei N eine beliebige ganze Zahl größer 0 und c die Lichtgeschwindigkeit ist.

2. Verfahren nach Anspruch 1, bei dem das optische Speichermedium (12) eine CD, DVD, Blue-ray-Discs, MDs oder MOs oder beliebige Kombinationen davon umfasst.

3. Verfahren nach einem der Ansprüche 1 oder 2, bei dem die Bestimmung der Relaxationsschwingungsfrequenz die Simulation oder Messung einer bestimmten Konfiguration des Laser-Betriebsstroms (50, 70), wie zum Beispiel eine bestimmte Wechselstrom- oder Gleichstrom-Betriebsstromkonfiguration umfasst.

**4.** Verfahren nach einem der Ansprüche 1 bis 3, bei dem der Strom (50, 70) für die Erzeugung eines pulsierenden Lichts (22) eingerichtet ist, das von dem Laser (18) zum externen Resonator emittiert wird, wobei die pulsierende Lichtemission (22) eine Serie optischer Ausgangsimpulse mit einem optischen Ausgangsimpuls (77) pro Periode (76) des Stroms umfasst und jeder optische Ausgangsimpuls (77) nur einen Relaxationsschwingungsimpuls zeigt.

**5.** System (10), umfassend einen Laser (18), der durch einen Strom (50, 70) betrieben wird, der für eine Erzeugung von pulsierendem Licht (22) eingerichtet ist, das von dem Laser (18) zu einem externen Resonator emittiert wird, wodurch eine optische Länge (L) von dem Laser (18) zu einem optischen Speichermedium (12) definiert wird, und **dadurch gekennzeichnet, dass** das System (10) eine optische Länge (L) aufweist, die durch:

$$L = N \cdot c / (2 \cdot ROF)$$

definiert ist, wobei N eine beliebige ganze Zahl größer null, ROF die Relaxationsschwingungsfrequenz des pulsierenden Lichts (22) und c die Lichtgeschwindigkeit ist.

**6.** System (10) nach Anspruch 5, bei dem das Stromsignal (50, 70) eine pulsierende Lichtemission (22) erzeugen kann, die von dem Laser (18) zum externen Resonator emittiert wird, wobei die pulsierende Lichtemission (22) eine Serie optischer Ausgangsimpulse mit einem optischen Ausgangsimpuls (77) pro Periode (76) des Stroms umfasst und jeder optische Ausgangsimpuls (77) nur einen Relaxationsschwingungsimpuls zeigt.

**Revendications**

**1.** Procédé de réduction du bruit de retour dans un système d'enregistrement/reproduction de données optiques (10) comprenant un laser (18) excité par un courant (50,70) pouvant générer une lumière pulsée (22) émise depuis ledit laser (18) vers une cavité externe définissant une longueur optique (L) dudit laser (18) à un support de mémorisation optique (12), et **caractérisé en ce que** ledit procédé comprend : (a) la détermination de la fréquence d'oscillation de relaxation (ROF) de ladite lumière pulsée (22), et (b) le réglage de ladite longueur optique (L) selon :

$$L = N \cdot c / (2 \cdot ROF),$$

où N est tout entier supérieur à 0, et c est la vitesse de la lumière.

**2.** Procédé suivant la revendication 1, dans lequel ledit support de mémorisation optique (12) comprend un CD, un DVD, des disques Blu-Ray, des MD, des Mos ou toute combinaison de ceux-ci.

**3.** Procédé suivant l'une quelconque des revendications 1 et 2, dans lequel ladite détermination de la fréquence d'oscillation de relaxation comprend la simulation ou la mesure d'une configuration de courant d'excitation de laser spécifique (50, 70), comme une configuration d'excitation par courant alternatif et par courant continu.

**4.** Procédé suivant l'une quelconque des revendications précédentes 1 à 3, dans lequel ledit courant (50, 70) sert à générer une lumière pulsée (22) émise depuis ledit laser (18) vers ladite cavité externe, dans lequel ladite émission de lumière pulsée (22) comprend une série d'impulsions de sortie optiques, ayant une impulsion de sortie optique (77) par période (76) dudit courant et chaque impulsion de sortie optique (77) ne présentant qu'une impulsion d'oscillation de relaxation.

**5.** Système (10) comprenant un laser (18) excité par un courant (50, 70) servant à générer une lumière pulsée (22) émise depuis ledit laser (18) vers une cavité externe définissant une longueur optique (L) dudit laser (18) à un support de mémorisation optique (12), et **caractérisé en ce que** ledit système (10) présente une longueur optique (L) définie par :

$$L = N \cdot c / (2 \cdot ROF),$$

où N est tout entier supérieur à zéro, ROF est la fréquence d'oscillation de relaxation de la lumière pulsée (22) et c est la vitesse de la lumière.

6. Système (10) suivant la revendication 5, dans lequel ledit signal de courant (50, 70) sert à générer une émission de lumière pulsée (22) émise depuis ledit laser (18) vers ladite cavité externe, dans lequel ladite émission de lumière pulsée (22) comprend une série d'impulsions de sortie optiques, ayant une impulsion de sortie optique (77) par période (76) dudit courant et chaque impulsion de sortie optique (77) ne présentant qu'une impulsion d'oscillation de relaxation.

EP 1 719 124 B1

FIG.1

FIG.2

FIG.3

**EP 1 719 124 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 0887898 A
- US 5034942 A
- US 5313448 A